(19) Europäisches Patentamt
European Patent Office
Office européen des brevets

(11) **EP 4 624 966 A1**

(12) **EUROPEAN PATENT APPLICATION**
published in accordance with Art. 153(4) EPC

(43) Date of publication:
**01.10.2025 Bulletin 2025/40**

(21) Application number: **24838585.8**

(22) Date of filing: **25.06.2024**

(51) International Patent Classification (IPC):
**G01R 31/66** $^{(2020.01)}$    **G01R 35/00** $^{(2006.01)}$
**H02J 3/32** $^{(2006.01)}$

(52) Cooperative Patent Classification (CPC):
**Y02E 40/30**

(86) International application number:
**PCT/CN2024/101304**

(87) International publication number:
**WO 2025/011329 (16.01.2025 Gazette 2025/03)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **13.07.2023 CN 202310856564**

(71) Applicant: **Solax Power Network
Technology (Zhejiang) Co., Ltd.
Zhejiang 311599 (CN)**

(72) Inventors:
• **WEI, Qikang
  Hangzhou, Zhejiang 311599 (CN)**
• **LIU, Chaohou
  Hangzhou, Zhejiang 311599 (CN)**
• **SHI, Xinmiao
  Hangzhou, Zhejiang 311599 (CN)**
• **CHENG, Liangliang
  Hangzhou, Zhejiang 311599 (CN)**
• **WANG, Kerou
  Hangzhou, Zhejiang 311599 (CN)**

(74) Representative: **Berggren Oy
P.O. Box 16
Eteläinen Rautatiekatu 10A
00101 Helsinki (FI)**

(54) **METHOD AND DEVICE FOR DETECTING INSTALLATION STATE OF CURRENT SENSOR**

(57) The present invention discloses a method and device for detecting an installation state of a current sensor. The method including: obtaining an initial reactive power of each phase of an inverter and an initial current sensor number for a current sensor installed to the phase; injecting a preset reactive power into each phase of the inverter one by one, and acquiring a first reactive power output from each phase of the inverter; determining one by one a matching current sensor for each reference phase based on a comparison result between a first difference and a first preset threshold and generating a matching current sensor number for each phase; adjusting an installation phase of each current sensor according to the matching current sensor number, injecting the preset reactive power to each phase of the inverter one by one, and acquiring a second reactive power output from each phase; and determining an installation direction of the matching current sensor for each phase based on a comparison result between the second difference and the first preset threshold. The present invention provides an effective method for detecting the installation phase position and installation direction of each current sensor on the inverter, thereby improving the installation efficiency of the inverter product.

obtaining an initial reactive power of each phase of an inverter and an initial current sensor number for a current sensor installed to the phase — 101

injecting a preset reactive power into each phase of the inverter one by one, and after each injection of the preset reactive power into one phase of the inverter, acquiring a first reactive power output from each phase of the inverter — 102

determining one by one a matching current sensor for each reference phase based on a comparison result between a first difference and a first preset threshold and generating a matching current sensor number for each phase, with the phase receiving the preset reactive power as the reference phase; wherein the first difference is an absolute value of a difference between the initial reactive power of each phase and the first reactive power output — 103

adjusting an installation phase of each current sensor according to the matching current sensor number, injecting the preset reactive power to each phase of the inverter one by one, and acquiring a second reactive power output from each phase — 104

determining an installation direction of the matching current sensor for each phase based on a comparison result between the second difference and the first preset threshold; wherein the second difference is a difference between the second reactive power and the first reactive power — 105

FIG. 1

## Description

## Technical Field

The present invention relates to the technical field of electrical technology, and in particular to a method and device for detecting the installation state of a current sensor.

## Background

An energy storage inverter is an inverter that can be connected to photovoltaics, batteries, household loads, and the power grid. Compared with a simple photovoltaic inverter, it can store excess photovoltaic energy in the battery so that it can provide energy to household loads even when there is no light. The energy management of the energy storage inverter is also relatively complex, and it is necessary to take into account the photovoltaic power generation power, battery capacity load power, and customer usage settings. For example, during the day, whether photovoltaic energy flows to the grid or is given priority to battery storage, and whether the energy is only used to power the load instead of flowing to the grid at night. These complex energy control functions require the inverter to perform fine control of the grid-connected power. Therefore, the inverter needs to be equipped with a current sensor (CT) to detect the grid-connected current in real time and calculate the power.

CT is usually a ring structure that can be opened and closed. When in use, open the CT and buckle it on the wire that needs to be sampled, and then close it. In the actual production and application of the inverter, the current sensor is often connected in the wrong position (installed on the Phase A/B, but in the actual process it is installed on phase A/C or B/C) or the direction is reversed (causing the positive and negative current test to be reversed). For a three-phase four-wire inverter, there are three wires of three phases A, B, C, corresponding to three CTs. Each CT must be correctly installed on the corresponding wire to obtain the correct current value. Therefore, the installation of CT requires special attention to its position. At present, the installation of CT mainly relies on professional installers to install it strictly according to the phase sequence and direction. In many cases, users do not know which wires the phases A, B, C correspond to. When the grid-connected power is relatively small, even if the CT is installed incorrectly, the inverter can still operate normally, and it is difficult for the installer to judge.

## Summary

The present application provides a method and device for detecting the installation state of a current sensor, which is used to detect the connection and matching relationship between each phase in an inverter and the current sensor, and provides an effective method for detecting the installation phase position and installation direction of each current sensor on the inverter, thereby improving the installation efficiency of the inverter product.

In a first aspect, the present application provides a method for detecting an installation state of a current sensor, including:

obtaining an initial reactive power of each phase of an inverter and an initial current sensor number for a current sensor installed to the phase;

injecting a preset reactive power into each phase of the inverter one by one, and after each injection of the preset reactive power into one phase of the inverter, acquiring a first reactive power output from each phase of the inverter;

determining one by one a matching current sensor for each reference phase based on a comparison result between a first difference and a first preset threshold and generating a matching current sensor number for each phase, with the phase receiving the preset reactive power as the reference phase; wherein the first difference is an absolute value of a difference between the initial reactive power of each phase and the first reactive power output;

adjusting an installation phase of each current sensor according to the matching current sensor number, injecting the preset reactive power to each phase of the inverter one by one, and acquiring a second reactive power output from each phase; and

determining an installation direction of the matching current sensor for each phase based on a comparison result between the second difference and the first preset threshold; wherein the second difference is a difference between the second reactive power and the first reactive power.

In this way, it sequentially controls each phase in the inverter to output a preset reactive power, and acquires the first reactive power of each phase after outputting the preset reactive power. Based on the comparison result of the absolute value of the difference between the first reactive power and the initial reactive power with the preset threshold, it is determined whether the current sensor installed to each phase is a corresponding matching sensor and the current sensor installed to each phase is adjusted according to the determination result. Further, after adjusting the installation phase of each current sensor according to the matching current sensor number, each phase is re-controlled to output the preset reactive power in turn, and the second reactive power of each phase is acquired. It is determined whether the installation direction of the current sensor on each phase is correct according to the comparison result of the difference between the second reactive power and the first reactive power with the preset threshold. Thus, an effective method is provided for detecting the installation phase position and installation direction of each current sensor on the inverter, thereby improving the installation efficiency of the inverter product.

In one implementation, the obtaining of the initial reactive power of each phase of the inverter includes:

controlling an active power output from each phase of the inverter to be zero; and obtaining the initial reactive power of each phase according to an initial reactive power calculation formula:

$$Q = \frac{1}{N} \sum_{i=0}^{N} V_i^q \times I_{ni};$$

wherein Q represents the initial reactive power; $N$ represents the number of calculation points within one power frequency cycle; $i$ represents an $i$-th point; $V_i^q$ represents a phase voltage of the reference phase rotated by 90 degrees; $I_{ni}$ represents a current in the current sensor; $n$ represents the initial current sensor number.

In one implementation, the determining of the matching current sensor for each reference phase based on the comparison result between the first difference and the first preset threshold includes:

taking each phase receiving the preset reactive power as the reference phase one by one; determining that there is an access fault when the first differences of non-reference phases other than the reference phase are simultaneously greater than the first preset threshold; wherein the access fault comprises a current sensor for a non-reference phase being connected to the reference phase and a current sensor being connected to a phase N; determining that the reference phase is connected to the matching current sensor when only the first difference of the reference phase is greater than the first preset threshold; and controlling the reactive output power of each phase of the inverter to be zero after the matching current sensor is determined for each phase.

In one implementation, the determining of the matching current sensor for each reference phase based on the comparison result between the first difference and the first preset threshold includes:

determining that the reference phase is connected to the matching current sensor when the first difference of the reference phase is greater than the first preset threshold; and determining that the matching current sensor for a non-reference phase is connected to the reference phase when the first difference of the reference phase is less than the first preset threshold and the first difference of the non-reference phase is greater than the first preset threshold.

In one implementation, preceding the adjusting of the installation phase of each current sensor according to the matching current sensor number, the method further includes:

performing duplicate detection on the matching current sensor numbers; and determining that there is an abnormal current sensor matching result and turning on an abnormal alarm when there are duplicate matching current sensor numbers for the installation phases.

In one implementation, the determining of the installation direction of the matching current sensor for each phase based on the comparison result between the second difference and the first preset threshold further includes:

determining that the installation direction of the matching current sensor is correct when it is determined that the second difference is greater than the first preset threshold; determining that the installation direction of the matching current sensor is reversed when it is determined that the second difference is less than a second preset threshold; wherein the second preset threshold is a negative value of the first preset threshold; and determining that an installation of the matching current sensor is abnormal and turning on an abnormal alarm when it is determined that the second difference is greater than or equal to the first preset threshold and that the second difference is less than or equal to the second preset threshold.

In one implementation, the method for detecting the installation state of the current sensor further includes determining of the installation state of the current sensor according to a sampled current value of the current sensor, which includes:

obtaining a sampled current value of the current sensor installed to each phase; determining that the current sensor has a risk of being disconnected when the sampled current value of the current sensor is detected to be less than a preset current value; wherein the preset current value is greater than an output current of the inverter when the current sensor is disconnected; and injecting a first preset reactive power into the installation phase corresponding to the current sensor, and determining that the current sensor is disconnected if the sampled current value of the current sensor does not change.

In a second aspect, the present application provides a device for detecting an installation state of a current sensor, including: a data acquisition module, a first control module, a first determination module, a second control module and a second determination module; wherein

the data acquisition module is configured to obtain an initial reactive power of each phase of an inverter and an initial current sensor number for a current sensor installed to the phase;

the first control module is configured to inject a preset reactive power into each phase of the inverter one by one, and after each injection of the preset reactive power into one phase of the inverter, acquire a first reactive power output from each phase of the inverter;

the first determination module is configured to determine one by one a matching current sensor for each reference phase based on a comparison result between a first difference and a first preset threshold and generate a matching current sensor number for each phase, with the phase receiving the preset reactive power as the reference phase; wherein the first difference is an absolute value of a difference between the initial reactive power of each phase and the first reactive power output;

the second control module is configured to adjust an installation phase of each current sensor according to the matching current sensor number, inject the preset reactive power to each phase of the inverter one by one, and acquire a second reactive power output from each phase;

the second determination module is configured to determine an installation direction of the matching current sensor for each phase based on a comparison result between the second difference and the first preset threshold; wherein the second difference is a difference between the second reactive power and the first reactive power.

In this way, it sequentially controls each phase in the inverter to output a preset reactive power, and acquires the first reactive power of each phase after outputting the preset reactive power. Based on the comparison result of the absolute value of the difference between the first reactive power and the initial reactive power with the preset threshold, it is determined whether the current sensor installed to each phase is a corresponding matching sensor and the current sensor installed to each phase is adjusted according to the determination result. Further, after adjusting the installation phase of each current sensor according to the matching current sensor number, each phase is re-controlled to output the preset reactive power in turn, and the second reactive power of each phase is acquired. It is determined whether the installation direction of the current sensor on each phase is correct according to the comparison result of the difference between the second reactive power and the first reactive power with the preset threshold. Thus, an effective method is provided for detecting the installation phase position and installation direction of each current sensor on the inverter, thereby improving the installation efficiency of the inverter product.

In one implementation, the obtaining of the initial reactive power of each phase of the inverter includes:

controlling an active power output from each phase of the inverter to be zero; and obtaining the initial reactive power of each phase according to an initial reactive power calculation formula:

$$Q = \frac{1}{N} \sum_{i=0}^{N} V_i^q \times I_{ni};$$

wherein Q represents the initial reactive power; $N$ represents the number of calculation points within one power frequency cycle; $i$ represents an i-th point; $V_i^q$ represents a phase voltage of the reference phase rotated by 90 degrees; $I_{ni}$ represents a current in the current sensor; $n$ represents the initial current sensor number.

In one implementation, the determining of the matching current sensor for each reference phase based on the comparison result between the first difference and the first preset threshold includes:

taking each phase receiving the preset reactive power as the reference phase one by one; determining that there is an access fault when the first differences of non-reference phases other than the reference phase are simultaneously greater than the first preset threshold; wherein the access fault comprises a current sensor for a non-reference phase being connected to the reference phase and a current sensor being connected to a phase N; determining that the reference phase is connected to the matching current sensor when only the first difference of the reference phase is greater than the first preset threshold; and controlling the reactive output power of each phase of the inverter to be zero after the matching current sensor is determined for each phase.

In one implementation, the determining of the matching current sensor for each reference phase based on the comparison result between the first difference and the first preset threshold includes:

determining that the reference phase is connected to the matching current sensor when the first difference of the reference phase is greater than the first preset threshold; and

determining that the matching current sensor for a non-reference phase is connected to the reference phase when the first difference of the reference phase is less than the first preset threshold and the first difference of the non-reference phase is greater than the first preset threshold.

In one implementation, preceding the adjusting of the installation phase of each current sensor according to the matching current sensor number, the method further includes:

> performing duplicate detection on the matching current sensor numbers; and
> determining that there is an abnormal current sensor matching result and turning on an abnormal alarm when there are duplicate matching current sensor numbers for the installation phases.

In one implementation, the determining of the installation direction of the matching current sensor for each phase based on the comparison result between the second difference and the first preset threshold further includes:

> determining that the installation direction of the matching current sensor is correct when it is determined that the second difference is greater than the first preset threshold;
> determining that the installation direction of the matching current sensor is reversed when it is determined that the second difference is less than a second preset threshold; wherein the second preset threshold is a negative value of the first preset threshold; and
> determining that an installation of the matching current sensor is abnormal and turning on an abnormal alarm when it is determined that the second difference is greater than or equal to the first preset threshold and that the second difference is less than or equal to the second preset threshold.

In one implementation, the method for detecting the installation state of the current sensor further includes determining of the installation state of the current sensor according to a sampled current value of the current sensor, which includes:

> obtaining a sampled current value of the current sensor installed to each phase;
> determining that the current sensor has a risk of being disconnected when the sampled current value of the current sensor is detected to be less than a preset current value; wherein the preset current value is greater than an output current of the inverter when the current sensor is disconnected; and
> injecting a first preset reactive power into the installation phase corresponding to the current sensor, and determining that the current sensor is disconnected if the sampled current value of the current sensor does not change.

In a third aspect, the present application provides terminal device, including: a processor, and a memory having stored thereon a computer program executable by the processor, wherein the computer program when executed by the processor implements the above method for detecting the installation state of the current sensor.

In a fourth aspect, the present application provides a computer-readable storage medium, having stored thereon a computer program, wherein the computer program when running controls an apparatus where the computer-readable storage medium resides to implement the above method for detecting the installation state of the current sensor.

## Brief Description of the Drawings

> FIG. 1 is a schematic flow chart of a method for detecting an installation state of a current sensor according to an embodiment of the present invention.
> FIG. 2 is a diagram showing the module structure of a device for detecting an installation state of a current sensor according to an embodiment of the present invention.

## Detailed Description of the Embodiments

The specific implementation of the present invention is further described in detail below in conjunction with the accompanying drawings and examples. The following examples are used to illustrate the present invention, but are not intended to limit the scope of the present invention.

The terms "first" and "second" and the like in the specification and claims of the present application and the drawings are used to distinguish different objects, rather than to describe a specific order. In addition, the terms "including" and "having" and any variations thereof are intended to cover non-exclusive inclusions. For example, a process, method, system, product or device including a series of steps or units is not limited to the listed steps or units, but may optionally include steps or units not listed, or may optionally include other steps or units inherent to these processes, methods, products or devices.

Reference to "example" herein means that a particular feature, structure, or characteristic described in conjunction with the embodiments may be included in at least one embodiment of the present application. The appearance of the wording in various locations in the specification does not necessarily refer to the same embodiment, nor is it an independent or alternative embodiment that is mutually exclusive with other embodiments. It is explicitly and implicitly understood by those skilled in the art that the embodiments described herein may be combined with other embodiments.

Example 1

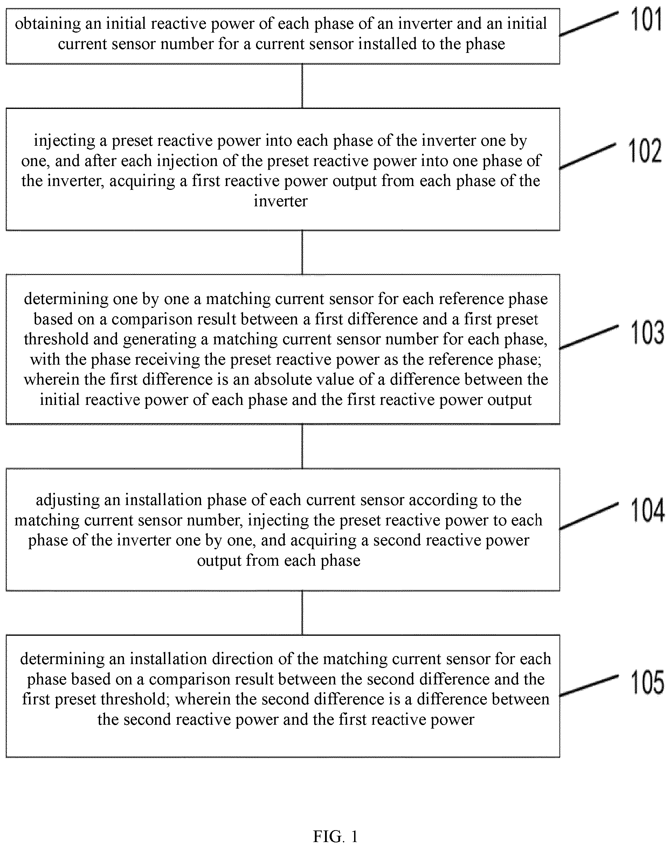

Referring to FIG. 1, which is a flow chart of a method for detecting the installation state of a current sensor according to an embodiment of the present invention. The present invention provides a method for detecting the installation state of a current sensor, including steps 101 to 105, and each step is specifically as follows:
Step 101, obtaining an initial reactive power of each phase of an inverter and an initial current sensor number for a current sensor installed to the phase.

By default, the inverter's Phase A is connected to the current sensor numbered CT1, the Phase B is connected to the current sensor numbered CT2, and the Phase C is connected to the current sensor numbered CT3. However, when detecting the installation state of the current sensor, many inverters may have performed CT identification or installed with the current sensors not according to the default situation, so it is necessary to obtain the initial current sensor number corresponding to each inverter. It should be noted that the initial current sensor number in the embodiment of the present invention is the current sensor number at the beginning of this installation state detection, rather than the first current sensor number of the current sensors installed for each phase of the inverter. In the embodiment of the present invention, taking the current sensor numbered CT3 for the Phase A, CT1 for the Phase B, and CT2 for the Phase C as an example, the initial current sensor numbers of each phase of the inverter are CTA= 3, CTB= 1, and CTC= 2.

In one embodiment, the obtaining of the initial reactive power of each phase of the inverter specifically includes:

controlling an active power output from each phase of the inverter to be zero; and
obtaining the initial reactive power of each phase according to an initial reactive power calculation formula:

$$Q = \frac{1}{N} \sum_{i=0}^{N} V_i^q \times I_{ni};$$

In the formula, Q represents the initial reactive power; $N$ represents the number of calculation points within one power frequency cycle; $i$ represents an $i$-th point; $V_i^q$ represents a phase voltage of the reference phase rotated by 90 degrees; $I_{ni}$ represents a current in the current sensor; $n$ represents the initial current sensor number.

When detecting the installation state of each current sensor, the active power output of the inverter is kept at 0 to reduce the interference of active power. In the embodiment of the present invention, a three-phase four-wire inverter is taken as an example, and the initial reactive powers $Q_A$, $Q_B$, $Q_C$ for the current three phases A, B, C of the inverter are obtained according to the calculation formula. Preferably, the initial reactive power of phase A is acquired as an example, if the current phase A receives reactive power Q1, the initial reactive power $Q_A$ is calculated as the average value of the product of voltage and current. The phase voltage of phase A rotated 90 degrees is multiplied by the current of CT3, and the average value is taken after calculating a full power frequency cycle to obtain the initial reactive power. Similarly, the initial reactive powers $Q_B$ and $Q_C$ of phases B and C can be obtained. The initial reactive power of phase A can be calculated based on the calculation formula for initial reactive power is expressed as follows:

$$Q_A = \frac{1}{N} \sum_{i=0}^{N} V_{Ai}^q \times I_{ni};$$

In the formula, $V_{Ai}^q$ represents the voltage of phase A rotated by 90 degrees, $I_{ni}$ represents the current on CTn, and n is the initial current sensor number currently considered by the inverter software, which may be 1, 2, or 3. For example, n=3 means that CT3 is currently considered to be connected to phase A. N represents the total number of calculation points within a power frequency cycle (50Hz), and i represents the i-th point. Assuming that the calculation frequency of the inverter software is 20kHz, then N=20kHz/50Hz=400. The initial reactive powers for phases B and C are calculated in the same way as above.

Step 102, injecting a preset reactive power into each phase of the inverter one by one, and after each injection of the preset reactive power into one phase of the inverter, acquiring a first reactive power output from each phase of the inverter.

Specifically, the steps for calculating the first reactive power are the same as those for calculating the initial reactive power. The preset reactive power is injected into each phase of the inverter one by one, that is, the output reactive power of each phase of the inverter is controlled one by one to be the preset reactive power. The preset reactive power is usually slightly larger than the sampling accuracy of the current sensor. Injecting excessive reactive power into the power grid will have an adverse effect on the sampling.

Step 103, determining one by one a matching current sensor for each reference phase based on a comparison result between a first difference and a first preset threshold and generating a matching current sensor number for each phase, with the phase receiving the preset reactive power as the reference phase; wherein the first difference is an absolute value of a difference between the initial reactive power of each phase and the first reactive power output.

In one embodiment, the determining of the matching current sensor for each reference phase based on the comparison result between the first difference and the first preset threshold specifically includes: taking each phase receiving the preset reactive power as the reference phase one by one; determining that there is an access fault when the first differences of non-reference phases other than the reference phase are simultaneously greater than the first preset threshold; wherein the access fault comprises a current sensor for a non-reference phase being connected to the reference phase and a current sensor being connected to a phase N; determining that the reference phase is connected to the matching current sensor when only the first difference of the reference phase is greater than the first preset threshold; and controlling the reactive output power of each phase of the inverter to be zero after the matching current sensor is determined for each phase. Taking the phase A currently receiving the preset reactive power as an example for explanation, when the first difference of the reference phase A is greater than the first preset threshold K, it can only be determined that CT is connected to the reference phase, and further analysis is required to determine the matching current sensor of the reference phase. If the first difference $\Delta QA$ of phase A satisfies: $\Delta QA > K$, the first difference $\Delta QB$ of phase B satisfies: $\Delta QB > K$, and the first difference $\Delta QC$ of phase C satisfies: $\Delta QC > K$, this means in the comparison results, except for the comparison result of the reference phase A, there are comparison results of the remaining phases satisfying as above, then it is determined that there is an abnormal connection and the abnormal alarm is turned on. Preferably, if the first difference $\Delta QA$ of phase A satisfies: $\Delta QA > K$ and the first difference $\Delta QB$ of phase B satisfies: $\Delta QB > K$, it indicates that two CTs are connected to phase A at this time or there is a CT connected to phase N. Phase N is any of the phases A, B, C injected with reactive power, and it will have current. When only the first difference $\Delta QA$ of phase A satisfies: $\Delta QA > K$, it is determined that phase A is connected to the matching current sensor, and after the determination is completed, the reactive output of the inverter is re-controlled to 0. It should be noted that in the embodiment of the present invention, the preset reactive power is injected into each phase of the inverter one by one, and the phase receiving the reactive power is used as the reference phase to determine whether the reference phase is connected to a matching current sensor, thereby realizing the detection of matching current sensors for the three phases. The specific order for the determination may be to determine the matching current sensor of the reference phase according to the first difference of the three phases each time the preset reactive power is injected, or to determine the matching current sensor of the reference phase according to the first difference of the three phases under different reference phases at the same time after all three phases have received the preset reactive powers. The specific phase in the inverter to be detected first may also be adjusted according to the detection progress or personal preference, without affecting the detection accuracy.

After the matching current sensor of phase A is determined, the preset reactive power Q1 is injected into phase B, and the first reactive powers QA1, QB1 and QC1 of the three phases A, B, C are re-recorded. The first reactive power of each phase can be obtained by multiplying the voltage of each phase and the current of the current sensor currently connected to each phase. The absolute value of the difference between the initial reactive power and the first reactive power of each phase is calculated, that is, the first differences $\Delta QA$, $\Delta QB$ and $\Delta QC$. The first difference of each phase is compared with the first preset threshold value K. When the first difference $\Delta QA$ of phase A satisfies: $\Delta QA > K$, it is determined that the CT that should be connected to phase B is actually connected to phase A , and CTBnew = 1 is recorded; when the first difference $\Delta QC$ of phase C satisfies: $\Delta QC > K$, it is determined that the CT that should be connected to phase B is actually connected to phase C, and CTBnew = 3 is recorded; when the first difference $\Delta QB$ of phase B satisfies: $\Delta QB > K$, it is determined that the CT that should be connected to phase B is really connected to phase B, and CTBnew = 2 is recorded. Finally, it is determined whether only one of the three conditions is satisfied, in other words, whether the first difference $\Delta QA$ of phase A satisfies: $\Delta QA > K$, the first difference $\Delta QB$ of phase B satisfies: $\Delta QB > K$, or the first difference $\Delta QC$ of phase C satisfies: $\Delta QC > K$. If not, an error is reported. After the determination is completed, the reactive output of the inverter is controlled to 0 again.

When the matching current sensor of phase B is determined, the preset reactive power Q1 is injected into phase C, and the first reactive powers QA1, QB1 and QC1 of the three phases A, B, C are re-recorded. With phase C as the reference phase, the current of the reference phase is multiplied by the voltage of each non-reference phase to obtain the first reactive power of each phase. The absolute value of the difference between the initial reactive power and the first reactive power of each phase is calculated, that is, the first differences $\Delta QA$, $\Delta QB$ and $\Delta QC$. The first difference of each phase is compared with the first preset threshold K. When the first difference $\Delta QA$ of phase A satisfies: $\Delta QA > K$, it is determined that the CT that should have been connected to phase C is actually connected to phase A, and CTCnew = 1 is recorded; if the first difference $\Delta QA$ of phase A satisfies: $\Delta QA < K$, it continues to determine the first difference of phase B. If the first difference $\Delta QB$ of phase B satisfies: $\Delta QB > K$, it is determined that the CT that should be connected to phase C is actually connected to phase B, and CTCnew = 2 is recorded; if the first difference $\Delta QB$ of phase B satisfies: $\Delta QB < K$, it con-

tinues to determine the first difference of phase C. If the first difference $\Delta QC$ of phase C satisfies: $\Delta QC > K$, it is determined that the CT that should be connected to phase C is actually connected to phase C, and CTCnew = 3 is recorded. Finally, it is determined whether only one of the three conditions is satisfied, in other words, whether the first difference $\Delta QA$ of phase A satisfies: $\Delta QA > K$, the first difference $\Delta QB$ of phase B satisfies: $\Delta QB > K$, or the first difference $\Delta QC$ of phase C satisfies: $\Delta QC > K$. If not, an error is reported. After the determination is completed, the reactive output of the inverter is controlled to 0 again. The determination process of matching current sensors to phases B and C is consistent with that of phase A. For the convenience and simplicity of description, the above description only describes the general determination process. The specific calculation method and principle can be referred to the aforementioned process of phase A, which will not be repeated here.

In one embodiment, the determining of the matching current sensor for each reference phase based on the comparison result between the first difference and the first preset threshold further includes: determining that the reference phase is connected to the matching current sensor when the first difference of the reference phase is greater than the first preset threshold; and determining that the matching current sensor for a non-reference phase is connected to the reference phase when the first difference of the reference phase is less than the first preset threshold and the first difference of the non-reference phase is greater than the first preset threshold; after the matching current sensor of each phase is determined, controlling the output reactive power of each phase of the inverter to be 0. In the embodiment of the present invention, the preset reactive power Q1 is injected into each phase of the inverter one by one. The value of the preset reactive power is greater than the minimum recognition accuracy value of the inverter to ensure that the injected reactive power can be accurately recognized by the inverter. Preferably, the phase A is controlled to output the preset reactive power Q1, and the first reactive powers QA1, QB1 and QC1 of the three phases A, B, C are recorded respectively at this time.

By multiplying the phase voltage on each phase with the current of the current sensor connected to the phase, the first reactive power of each phase can be obtained, that is, QA1=UA*IA, QB1=UB*IB, QC1=UC*IC; due to the 120 degree difference in the three-phase system, UA=Usin $\Theta$, UB=Usin ($\Theta$ -120), UC=Usin ($\Theta$ +120). Since IA, IB, and IC are determined by the position of the CT connection, IA, IB, and IC are unknown. For example, when reactive power is injected into phase A, if the current sensors connected to phase A, phase B, and phase C are initially considered to be numbered CT1, CT2, and CT3, when CT1 is connected to phase A, IA = Isin ($\Theta$+90), IB = IC =0; when CT2 is connected to phase A, IB = Isin ($\Theta$+90), IA = IC =0; when CT3 is connected to phase A, IC = Isin ($\Theta$+90), IA = IB =0; in addition, when a CT is connected to phase A, but the connection direction of the CT is reversed, the corresponding current will become the corresponding reverse direction, that is, -I sin ($\Theta$+90); or when a CT is connected to the line N, the current of the line N is equal to the negative sum of the currents of the three phases A, B, C, so the current corresponding to the CT is also -I sin ($\Theta$+90).

The absolute value of the difference between the initial reactive power of each phase and the first reactive power is calculated, that is, the first difference is calculated, which are $\Delta QA=|QA1-QA|$, $\Delta QB=|QB1-QB|$ and $\Delta QC=|QC1-QC|$. The first difference of each phase is compared with the first preset threshold value K. The value range of the first preset threshold value is (0, Q1). According to the calculation formula for reactive power of each phase in the three-phase system, if it is considered that the current sensors connected to phase A, phase B and phase C are numbered CT1, CT2 and CT3 in the initial state, but in fact, the current sensors numbered CT2 , CT1 and CT3 are connected to phase A, phase B and phase C in order. If the preset reactive power Q1 is injected into phase A at this time, there is current passing through CT2, and there is no data in CT1 and CT3, that is, IA=IC=0, IB=CT2. The calculation for reactive power is performed based on QA1=UA*IA, QB1=UB*IB, QC1=UC*IC. Therefore, QA1=QC1=0 can be obtained, and QB1=UB*IB=UB*CT2=UB*IA (current of phase A) =1/2 QA1. That is, when phase A outputs the preset reactive power Q1, the first reactive power QB1 in phase B is actually only half of QA1. Preferably, in order to improve the determination accuracy of the matching current sensor, the first preset threshold value K is generally slightly smaller than Q1/2. The first difference of each phase is compared with the first preset threshold value K, and the following situations may be included according to the comparison result:

When $\Delta QA > K$, that is, the first difference of the reference phase A is greater than the first preset threshold K, it is considered that the current phase A is connected to the CT, and CTAnew = 1.
When $\Delta QA < K$, and $\Delta QB > K$, it is considered that the CT that should have been connected to phase B is actually connected to phase A, and CTAnew = 2.
When $\Delta QB < K$, and $\Delta QC > K$, it is considered that the CT that should be connected to phase C is actually connected to phase A, and CTAnew = 3.

Step 104, adjusting an installation phase of each current sensor according to the matching current sensor number, injecting the preset reactive power to each phase of the inverter one by one, and acquiring a second reactive power output from each phase.

In one embodiment, preceding the adjusting of the installation phase of each current sensor according to the matching current sensor number, it also includes: performing duplicate detection on the matching current sensor numbers; and determining that there is an abnormal current sensor matching result and turning on an abnormal alarm when there are duplicate matching current sensor numbers for the installation phases. The matching current sensor numbers CTAnew, CTBnew and CTCnew generated by the determination results of the matching current sensors of the three phases A, B, C are repeatedly detected. When there is a duplicate matching current sensor number for the installation phase, preferably, when the preset reactive power Q1 is injected into each phase one by one, and the matching current sensor of the reference phase is determined only by comparing the first difference of the reference phase with the first preset threshold K, it is necessary to perform repeatability detection on the generated matching current sensor number. If CTAnew=1 and CTBnew=1, it means that there is a CT connected to both phase A and phase B, which is obviously wrong. It is determined that there is an abnormal current sensor matching result at this time, and the abnormal alarm is turned on. In the embodiment of the present invention, the inverter software considers that phase A is connected to CT3, phase B is connected to CT1, and phase C is connected to CT2, that is, CTA=3, CTB=1, and CTC=2. After matching the current sensor installation results based on the method for detecting the installation of the current sensor according to the present application, it is considered that the CT of phase B is connected to phase A, the CT of phase C is connected to phase B, and the CT of phase A is connected to phase C, that is, CTAnew = 2, CTBnew = 3, and CTCnew = 1. When there is no repeated calibration of the matching current sensor number, the matching current sensor of each phase can be determined according to the values of CTAnew, CTBnew, and CTCnew, that is, CTAfinal = CTB, CTBfinal = CTC, and CTCfinal = CTA. Substituting the values of CTA, CTB, and CTC, CTAfinal = 1, CTBfinal = 2, and CTCfinal = 3 can be obtained. That is, the final CT installation positions are that CT1 is connected to phase A, CT2 is connected to phase B, and CT3 is connected to phase C. The installation phase of the current sensor is adjusted according to the current sensor number.

Step 105, determining an installation direction of the matching current sensor for each phase based on a comparison result between the second difference and the first preset threshold; wherein the second difference is a difference between the second reactive power and the first reactive power.

After each phase is connected to the corresponding matching current sensor, it is also necessary to determine whether the installation direction of each current sensor is correct. In one embodiment, the determining of the installation direction of the matching current sensor for each phase based on the comparison result between the second difference and the first preset threshold specifically includes: determining that the installation direction of the matching current sensor is correct when it is determined that the second difference is greater than the first preset threshold; determining that the installation direction of the matching current sensor is reversed when it is determined that the second difference is less than a second preset threshold; wherein the second preset threshold is a negative value of the first preset threshold; and determining that an installation of the matching current sensor is abnormal and turning on an abnormal alarm when it is determined that the second difference is greater than or equal to the first preset threshold and that the second difference is less than or equal to the second preset threshold. When determining the installation direction of the matching current sensor of each phase, the preset reactive power Q1 is input to each phase in turn, and the second reactive powers QA2, QB2 and QC2 of the phases are calculated. The value of the preset reactive power Q1 and the calculation method of the second reactive power are consistent with those described above, and are not repeated here. Preferably, an example is given to determine the installation direction of the matching current sensor of phase A, a preset reactive power Q1 is injected into phase A, and the second reactive power QA2 of phase A is calculated. The installation direction of the current sensor is then determined by comparing the difference $\Delta QA2$ between the second reactive power QA2 and the first reactive power QA1 with the first preset threshold, wherein $\Delta QA2=QA1-QA2$, and the value range of the first preset threshold K is (0, Q1). When determining the installation direction of the current sensor, the accuracy of the judgment can be improved by further narrowing the value range of the first preset threshold K, and it is preferred to be greater than Q1/2 and slightly less than Q1. When $\Delta QA2 > K$, it is determined that the installation direction of the CT is correct; when $\Delta QA2 < -K$, it is determined that the installation direction of the CT is reversed; if neither is satisfied, an error is reported. If the installation direction of the current sensor is wrong, the CT sampled current value needs to be reversed. For example, if CTAfinal=2, when calculating the active power and reactive power of phase A, the current value of CT2 must be inverted before calculation. The installation direction of the current sensors of phases B and C is the same as that of phase A, so it will not be described here.

When the current sensor falls off, its sampled current value is close to 0, and the subsequent system may be abnormally operated due to the current sensor falling off during the use of the inverter. The method for detecting the installation state of a current sensor according to an embodiment of the present invention also includes determining of the installation state of the current sensor according to a sampled current value of the current sensor, specifically including: obtaining a sampled current value of the current sensor installed to each phase; determining that the current sensor has a risk of being disconnected when the sampled current value of the current sensor is detected to be less than a preset current value; wherein the preset current value is greater than an output current of the inverter when the current sensor is disconnected; and injecting a first preset reactive power into the installation phase corresponding to the current sensor, and determining that the current sensor is disconnected if the sampled current value of the current sensor does not change. When the effective value of the sampled current of the current sensor is less than the preset current value K2, it can be determined that the current sensor has a risk of falling off. The value of K2 is greater than the current value of the CT of the inverter when it falls off. Preferably, the current value of the CT of the inverter is measured to be 0.1A when the CT falls off, and the value of the preset current value K2 can be set to 0.3A. The larger the value of K2 is designed to be, the greater the probability of erroneous determination on the CT for its falling off. The detection of CT's falling off requires the inverter to output reactive power, so it is more likely to affect normal operation. The smaller the value of K2 is designed to be, the more likely it is that the CT will not be accurately identified even if it actually falls off. The value of K2 can be adjusted according to the working accuracy requirements of the inverter and the specific application. When it is determined that the current sensor is at risk of falling off, the first preset reactive power Q2 is injected into the installation phase of the current sensor. If the sampled current value of the current sensor changes at this time, it can be determined that the current sensor is still in normal operation at this time and has not fallen off. The value of the first preset reactive power Q2 is set based on the rated power of the inverter. Preferably, the value can be 1% of the rated power of the inverter. For example, if the rated power is 5000W, 50Var is injected to observe whether the current of the CT increases to determine whether the CT falls off.

In an embodiment of the present invention, it also provides an apparatus for detecting an installation state of a current sensor, the apparatus including a processor, a memory, and a computer program stored in the memory and configured to be executed by the processor. When the processor executes the computer program, the above-mentioned method for detecting an installation state of a current sensor is implemented.

In an embodiment of the present invention, a computer-readable storage medium is further provided. The computer-readable storage medium includes a stored computer program. When the computer program is executed, the device where the computer-readable storage medium is located is controlled to perform the above-mentioned method for detecting an installation state of a current sensor.

Exemplarily, the computer program may be divided into one or more modules, which are stored in the memory and executed by the processor to complete the present invention. The one or more modules may be a series of instruction segments of computer program capable of completing specific functions, which are used to describe the execution process of the computer program in the apparatus for detecting an installation state of a current sensor.

The apparatus for detecting an installation state of a current sensor may be a computing device such as a desktop computer, a notebook, a PDA, and a cloud server. The apparatus for detecting an installation state of a current sensor may include, but is not limited to, a processor, a memory, and a display. Those skilled in the art can understand that the above-mentioned components are merely examples of the apparatus for detecting an installation state of a current sensor, and do not constitute a limitation on the apparatus for detecting an installation state of a current sensor. It may include more or less components than the above-mentioned components, or combine certain components, or different components. For example, the apparatus for detecting an installation state of a current sensor may also include input and output devices, network access devices, buses, etc.

The processor may be a central processing unit (CPU), or other general-purpose processors, digital signal processors (DSP), application-specific integrated circuits (ASIC), field-programmable gate arrays (FPGA) or other programmable logic devices, discrete gate or transistor logic devices, discrete hardware components, etc. The general-purpose processor may be a microprocessor or any conventional processor, etc. The processor is the control center of the apparatus for detecting an installation state of a current sensor, and uses various interfaces and lines to connect various parts of the apparatus for detecting an installation state of a current sensor.

The memory can be used to store the computer program and/or module, and the processor realizes various functions of the apparatus for detecting an installation state of a current sensor by running or executing the computer program and/or module stored in the memory, and calling the data stored in the memory. The memory can mainly include a program storage area and a data storage area, wherein the program storage area can store an operating system, an application required for at least one function (such as a sound playback function, a text conversion function, etc.), etc.; the data storage area can store data created according to the use of the mobile phone (such as audio data, text message data, etc.), etc. In addition, the memory can include a high-speed random access memory, and can also include a non-volatile memory, such as a hard disk, a memory, a plug-in hard disk, a smart memory card (Smart Media Card, SMC), a secure digital (Secure Digital, SD) card, a flash card (Flash Card), at least one disk storage device, a flash memory device, or other volatile solid-state storage devices.

If the module integrated in the apparatus for detecting an installation state of a current sensor is implemented in the form of a software functional unit and sold or used as an independent product, it can be stored in a computer-readable storage medium. Based on such an understanding, all or part of the processes in the above-mentioned method according to the present application can also be implemented by the relevant hardware instructed by a computer program. The computer program can be stored in a computer-readable storage medium, and the computer program can implement the steps of the above-mentioned various method embodiments when executed by the processor. The computer program includes computer program code, which may be in source code form, object code form, executable file or some intermediate form, etc. The computer-readable medium may include: any entity or device capable of carrying the computer program code, recording medium, U disk, mobile hard disk, disk, optical disk, computer memory, read-only memory (ROM, Read-Only Memory), random access memory (RAM, Random Access Memory), electrical carrier signal, telecommunication signal and software distribution medium, etc. It should be noted that the content contained in the computer-readable medium can be appropriately increased or decreased according to the requirements of legislation and patent practice in the jurisdiction. For example, in some jurisdictions, according to legislation and patent practice, the computer-readable medium does not include electric carrier signals and telecommunication signals. A skilled person in this field can understand and implement it without creative work.

The embodiment of the present invention provides a method for detecting an installation state of a current sensor, which sequentially controls each phase in the inverter to output a preset reactive power, and acquires the first reactive power of each phase after outputting the preset reactive power. Based on the comparison result of the absolute value of the difference between the first reactive power and the initial reactive power with the preset threshold, it is determined whether the current sensor installed to each phase is a corresponding matching sensor and the current sensor installed to each phase is adjusted according to the determination result. Further, after adjusting the installation phase of each current sensor according to the matching current sensor number, each phase is re-controlled to output the preset reactive power in turn, and the second reactive power of each phase is acquired. It is determined whether the installation direction of the current sensor on each phase is correct according to the comparison result of the difference between the second reactive power and the first reactive power with the preset threshold. Thus, an effective method is provided for detecting the installation phase position and installation direction of each current sensor on the inverter, thereby improving the installation efficiency of the inverter product.

Example 2

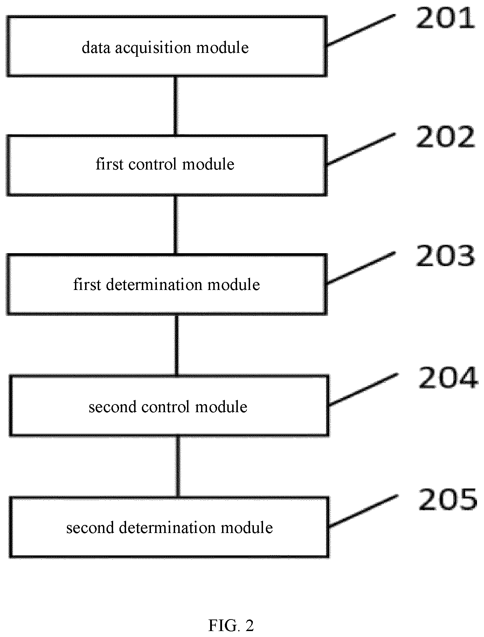

Referring to FIG. 2, which is a diagram showing the module structure of a device for detecting an installation state of a current sensor according to an embodiment of the present invention. The present invention provides a device for detecting an installation state of a current sensor, including: a data acquisition module 201, a first control module 202, a first determination module 203, a second control module 204 and a second determination module 205.

The data acquisition module 201 is configured to obtain an initial reactive power of each phase of an inverter and an initial current sensor number for a current sensor installed to the phase.

The first control module 202 is configured to inject a preset reactive power into each phase of the inverter one by one, and after each injection of the preset reactive power into one phase of the inverter, acquire a first reactive power output from each phase of the inverter.

The first determination module 203 is configured to determine one by one a matching current sensor for each reference phase based on a comparison result between a first difference and a first preset threshold and generate a matching current sensor number for each phase, with the phase receiving the preset reactive power as the reference phase; wherein the first difference is an absolute value of a difference between the initial reactive power of each phase and the first reactive power output.

The second control module 204 is configured to adjust an installation phase of each current sensor according to the matching current sensor number, inject the preset reactive power to each phase of the inverter one by one, and acquire a second reactive power output from each phase.

The second determination module 205 is configured to determine an installation direction of the matching current sensor for each phase based on a comparison result between the second difference and the first preset threshold; wherein the second difference is a difference between the second reactive power and the first reactive power.

In one embodiment, the obtaining of the initial reactive power of each phase of the inverter includes:

controlling an active power output from each phase of the inverter to be zero; and
obtaining the initial reactive power of each phase according to an initial reactive power calculation formula:

$$Q = \frac{1}{N} \sum_{i=0}^{N} V_i^q \times I_{ni};$$

wherein Q represents the initial reactive power; $N$ represents the number of calculation points within one power frequency cycle; $i$ represents an $i$-th point; $V_i^q$ represents a phase voltage of the reference phase rotated by 90 degrees; $I_{ni}$ represents a current in the current sensor; $n$ represents the initial current sensor number.

In one embodiment, the determining of the matching current sensor for each reference phase based on the comparison result between the first difference and the first preset threshold includes: taking each phase receiving the preset reactive power as the reference phase one by one; determining that there is an access fault when the first differences of non-reference phases other than the reference phase are simultaneously greater than the first preset threshold; wherein the access fault comprises a current sensor for a non-reference phase being connected to the reference phase and a current sensor being connected to a phase N; determining that the reference phase is connected to the matching current sensor when only the first difference of the reference phase is greater than the first preset threshold; and controlling the reactive output power of each phase of the inverter to be zero after the matching current sensor is determined for each phase.

In one embodiment, the determining of the matching current sensor for each reference phase based on the comparison result between the first difference and the first preset threshold includes: determining that the reference phase is connected to the matching current sensor when the first difference of the reference phase is greater than the first preset threshold; and determining that the matching current sensor for a non-reference phase is connected to the reference phase when the first difference of the reference phase is less than the first preset threshold and the first difference of the non-reference phase is greater than the first preset threshold.

In one embodiment, preceding the adjusting of the installation phase of each current sensor according to the matching current sensor number, it further includes:

performing duplicate detection on the matching current sensor numbers; and
determining that there is an abnormal current sensor matching result and turning on an abnormal alarm when there are duplicate matching current sensor numbers for the installation phases.

In one embodiment, the determining of the installation direction of the matching current sensor for each phase based on the comparison result between the second difference and the first preset threshold specifically includes:

determining that the installation direction of the matching current sensor is correct when it is determined that the second difference is greater than the first preset threshold;
determining that the installation direction of the matching current sensor is reversed when it is determined that the second difference is less than a second preset threshold; wherein the second preset threshold is a negative value of the first preset threshold; and
determining that an installation of the matching current sensor is abnormal and turning on an abnormal alarm when it is determined that the second difference is greater than or equal to the first preset threshold and that the second difference is less than or equal to the second preset threshold.

In one embodiment, the device for detecting an installation state of a current sensor further includes a state detection module for determining the installation state of the current sensor according to a sampled current value of the current sensor, specifically including:

obtaining a sampled current value of the current sensor installed to each phase;
determining that the current sensor has a risk of being disconnected when the sampled current value of the current sensor is detected to be less than a preset current value; wherein the preset current value is greater than an output current of the inverter when the current sensor is disconnected; and
injecting a first preset reactive power into the installation phase corresponding to the current sensor, and determining that the current sensor is disconnected if the sampled current value of the current sensor does not change.

Those skilled in the art can clearly understand that, for the convenience and brevity of description, the specific working process of the device described above can refer to the corresponding process in the aforementioned method embodiments, and will not be repeated here.

The embodiments of the present invention provide a device for detecting an installation state of a current sensor, which sequentially controls each phase in the inverter to output a preset reactive power, and acquires the first reactive power of each phase after outputting the preset reactive power. Based on the comparison result of the absolute value of the difference between the first reactive power and the initial reactive power with the preset threshold, it is determined whether the current sensor installed to each phase is a corresponding matching sensor and the current sensor installed to each phase is adjusted according to the determination result. Further, after adjusting the installation phase of each current sensor according to the matching current sensor number, each phase is re-controlled to output the preset reactive power in turn, and the second reactive power of each phase is acquired. It is determined whether the installation direction of the current sensor on each phase is correct according to the comparison result of the difference between the second reactive power and the first reactive power with the preset threshold. Thus, an effective method is provided for detecting the installation phase position and installation direction of each current sensor on the inverter, thereby improving the installation efficiency of the inverter product.

The above is only preferred embodiments of the present invention. It should be pointed out that for ordinary technicians in this technical field, several improvements and substitutions can be made without departing from the technical principles of the present invention. These improvements and substitutions should also be regarded as the scope of protection of the present invention.

**Claims**

1. A method for detecting an installation state of a current sensor, **characterized by** comprising:

   obtaining an initial reactive power of each phase of an inverter and an initial current sensor number for a current sensor installed to the phase; injecting a preset reactive power into each phase of the inverter one by one, and after each injection of the preset reactive power into one phase of the inverter, acquiring a first reactive power output from each phase of the inverter; determining one by one a matching current sensor for each reference phase based on a comparison result between a first difference and a first preset threshold and generating a matching current sensor number for each phase, with the phase receiving the preset reactive power as the reference phase; wherein the first difference is an absolute value of a difference between the initial reactive power of each phase and the first reactive power output; adjusting an installation phase of each current sensor according to the matching current sensor number, injecting the preset reactive power to each phase of the inverter one by one, and acquiring a second reactive power output from each phase; and determining an installation direction of the matching current sensor for each phase based on a comparison result between the second difference and the first preset threshold; wherein the second difference is a difference between the second reactive power and the first reactive power.

2. The method for detecting the installation state of the current sensor according to claim 1, **characterized in that** the obtaining of the initial reactive power of each phase of the inverter comprises:

   controlling an active power output from each phase of the inverter to be zero; and obtaining the initial reactive power of each phase according to an initial reactive power calculation formula:

$$Q = \frac{1}{N} \sum_{i=0}^{N} V_i^q \times I_{ni};$$

wherein Q represents the initial reactive power; $N$ represents the number of calculation points within one power frequency cycle; $i$ represents an $i$-th point; $V_i^q$ represents a phase voltage of the reference phase rotated by 90 degrees; $I_{ni}$ represents a current in the current sensor; $n$ represents the initial current sensor number.

3. The method for detecting the installation state of the current sensor according to claim 1, **characterized in that** the determining of the matching current sensor for each reference phase based on the comparison result between the first difference and the first preset threshold comprises:

   taking each phase receiving the preset reactive power as the reference phase one by one; determining that there is an access fault when the first differences of non-reference phases other than the reference phase are simultaneously greater than the first preset threshold; wherein the access fault comprises a current sensor for a non-reference phase being connected to the reference phase and a current sensor being connected to a phase N; determining that the reference phase is connected to the matching current sensor when only the first difference of the reference phase is greater than the first preset threshold; and controlling the reactive output power of each phase of the inverter to be zero after the matching current sensor is determined for each phase.

4. The method for detecting the installation state of the current sensor according to claim 1, **characterized in that** the determining of the matching current sensor for each reference phase based on the comparison result between the first difference and the first preset threshold comprises:

   determining that the reference phase is connected to the matching current sensor when the first difference of the reference phase is greater than the first preset threshold; and determining that the matching current sensor for a non-reference phase is connected to the reference phase when the first difference of the reference phase is less than the first preset threshold and the first difference of the non-reference phase is greater than the first preset threshold.

5. The method for detecting the installation state of the current sensor according to claim 1, **characterized**

**in that** preceding the adjusting of the installation phase of each current sensor according to the matching current sensor number, the method further comprises:

performing duplicate detection on the matching current sensor numbers; and
determining that there is an abnormal current sensor matching result and turning on an abnormal alarm when there are duplicate matching current sensor numbers for the installation phases.

6. The method for detecting the installation state of the current sensor according to claim 1, **characterized in that** the determining of the installation direction of the matching current sensor for each phase based on the comparison result between the second difference and the first preset threshold further comprises:

determining that the installation direction of the matching current sensor is correct when it is determined that the second difference is greater than the first preset threshold;
determining that the installation direction of the matching current sensor is reversed when it is determined that the second difference is less than a second preset threshold; wherein the second preset threshold is a negative value of the first preset threshold; and
determining that an installation of the matching current sensor is abnormal and turning on an abnormal alarm when it is determined that the second difference is greater than or equal to the first preset threshold and that the second difference is less than or equal to the second preset threshold.

7. The method for detecting the installation state of the current sensor according to claim 1, **characterized by** further comprising determining of the installation state of the current sensor according to a sampled current value of the current sensor, which comprises:

obtaining a sampled current value of the current sensor installed to each phase;
determining that the current sensor has a risk of being disconnected when the sampled current value of the current sensor is detected to be less than a preset current value; wherein the preset current value is greater than an output current of the inverter when the current sensor is disconnected; and
injecting a first preset reactive power into the installation phase corresponding to the current sensor, and determining that the current sensor is disconnected if the sampled current value of the current sensor does not change.

8. A device for detecting an installation state of a current sensor, **characterized by** comprising:

a data acquisition module, configured to obtain an initial reactive power of each phase of an inverter and an initial current sensor number for a current sensor installed to the phase;
a first control module, configured to inject a preset reactive power into each phase of the inverter one by one, and after each injection of the preset reactive power into one phase of the inverter, acquire a first reactive power output from each phase of the inverter;
a first determination module, configured to determine one by one a matching current sensor for each reference phase based on a comparison result between a first difference and a first preset threshold and generate a matching current sensor number for each phase, with the phase receiving the preset reactive power as the reference phase; wherein the first difference is an absolute value of a difference between the initial reactive power of each phase and the first reactive power output;
a second control module, configured to adjust an installation phase of each current sensor according to the matching current sensor number, inject the preset reactive power to each phase of the inverter one by one, and acquire a second reactive power output from each phase; and
a second determination module, configured to determine an installation direction of the matching current sensor for each phase based on a comparison result between the second difference and the first preset threshold; wherein the second difference is a difference between the second reactive power and the first reactive power.

9. A terminal device, **characterized by** comprising:

a processor,
a memory having stored thereon a computer program executable by the processor, wherein the computer program when executed by the processor implements the method for detecting the installation state of the current sensor according to any one of claims 1 to 7.

10. A computer-readable storage medium, **characterized by** having stored thereon a computer program, wherein the computer program when running controls an apparatus where the computer-readable storage medium resides to implement the method for detecting the installation state of the current sensor according to any one of claims 1 to 7.

obtaining an initial reactive power of each phase of an inverter and an initial current sensor number for a current sensor installed to the phase $\qquad$ 101

injecting a preset reactive power into each phase of the inverter one by one, and after each injection of the preset reactive power into one phase of the inverter, acquiring a first reactive power output from each phase of the inverter $\qquad$ 102

determining one by one a matching current sensor for each reference phase based on a comparison result between a first difference and a first preset threshold and generating a matching current sensor number for each phase, with the phase receiving the preset reactive power as the reference phase; wherein the first difference is an absolute value of a difference between the initial reactive power of each phase and the first reactive power output $\qquad$ 103

adjusting an installation phase of each current sensor according to the matching current sensor number, injecting the preset reactive power to each phase of the inverter one by one, and acquiring a second reactive power output from each phase $\qquad$ 104

determining an installation direction of the matching current sensor for each phase based on a comparison result between the second difference and the first preset threshold; wherein the second difference is a difference between the second reactive power and the first reactive power $\qquad$ 105

FIG. 1

FIG. 2

## INTERNATIONAL SEARCH REPORT

| International application No. |
|---|
| **PCT/CN2024/101304** |

| | |
|---|---|
| **A. CLASSIFICATION OF SUBJECT MATTER** | |
| G01R31/66(2020.01)i; G01R35/00(2006.01)i; H02J3/32(2006.01)n | |
| According to International Patent Classification (IPC) or to both national classification and IPC | |

| |
|---|
| **B. FIELDS SEARCHED** |
| Minimum documentation searched (classification system followed by classification symbols) |
| IPC:G01R31; G01R35; H02J3 |
| Documentation searched other than minimum documentation to the extent that such documents are included in the fields searched |
| Electronic data base consulted during the international search (name of data base and, where practicable, search terms used) |
| CNABS, CNTXT, CNKI: 电流传感器, 安装, 位置, 方向, 无功功率, 比较, 编号, 调整, 依次, 注入, 扰动, 脱落; VEN, USTXT, WOTXT, EPTXT, WEB OF SCIENCE: CT, installation, location, orientation, reactive power, comparison, numbering, adjusting, sequencing, injection, disturbance, dropping |

**C. DOCUMENTS CONSIDERED TO BE RELEVANT**

| Category* | Citation of document, with indication, where appropriate, of the relevant passages | Relevant to claim No. |
|---|---|---|
| PX | CN 116930841 A (ZHEJIANG SOLAX POWER NETWORK ENERGY TECHNOLOGY CO., LTD.) 24 October 2023 (2023-10-24) <br> description, paragraphs 4-68 | 1-10 |
| Y | CN 112462303 A (ZHEJIANG SOLAX POWER NETWORK ENERGY TECHNOLOGY CO., LTD.) 09 March 2021 (2021-03-09) <br> description, paragraphs 18-37, and figure 1 | 1-10 |
| Y | CN 103869210 A (STATE GRID CORPORATION OF CHINA et al.) 18 June 2014 (2014-06-18) <br> description, paragraphs 29-65 | 1-10 |
| Y | JP 2020092532 A (SUMITOMO ELECTRIC INDUSTRIES, LTD.) 11 June 2020 (2020-06-11) <br> description, paragraphs 26-60 | 1-10 |
| A | JP 2013072760 A (AISIN SEIKI CO., LTD. et al.) 22 April 2013 (2013-04-22) <br> entire document | 1-10 |

| ☑ Further documents are listed in the continuation of Box C. | ☑ See patent family annex. |
|---|---|

| | |
|---|---|
| * Special categories of cited documents: <br> "A" document defining the general state of the art which is not considered to be of particular relevance <br> "D" document cited by the applicant in the international application <br> "E" earlier application or patent but published on or after the international filing date <br> "L" document which may throw doubts on priority claim(s) or which is cited to establish the publication date of another citation or other special reason (as specified) <br> "O" document referring to an oral disclosure, use, exhibition or other means <br> "P" document published prior to the international filing date but later than the priority date claimed | "T" later document published after the international filing date or priority date and not in conflict with the application but cited to understand the principle or theory underlying the invention <br> "X" document of particular relevance; the claimed invention cannot be considered novel or cannot be considered to involve an inventive step when the document is taken alone <br> "Y" document of particular relevance; the claimed invention cannot be considered to involve an inventive step when the document is combined with one or more other such documents, such combination being obvious to a person skilled in the art <br> "&" document member of the same patent family |

| Date of the actual completion of the international search | Date of mailing of the international search report |
|---|---|
| **09 September 2024** | **13 September 2024** |

| Name and mailing address of the ISA/CN | Authorized officer |
|---|---|
| **China National Intellectual Property Administration (ISA/ CN)** <br> **China No. 6, Xitucheng Road, Jimenqiao, Haidian District, Beijing 100088** | |
| | Telephone No. |

Form PCT/ISA/210 (second sheet) (July 2022)

**INTERNATIONAL SEARCH REPORT**

| International application No. |
| --- |
| **PCT/CN2024/101304** |

**C.    DOCUMENTS CONSIDERED TO BE RELEVANT**

| Category* | Citation of document, with indication, where appropriate, of the relevant passages | Relevant to claim No. |
| --- | --- | --- |
| A | WO 2019082431 A1 (SUMITOMO ELECTRIC INDUSTRIES, LTD.) 02 May 2019 (2019-05-02)<br>    entire document | 1-10 |
| A | JP 2014130057 A (KYOCERA CORP.) 10 July 2014 (2014-07-10)<br>    entire document | 1-10 |
| A | JP 2020054091 A (SHARP K.K.) 02 April 2020 (2020-04-02)<br>    entire document | 1-10 |
| A | 王松楠 等 (WANG, Songnan et al.). "在线安装高精度直流弱电流传感器的研究 (Research on Online Installation High Precision DC Weak Current Sensor)"<br>东北电力大学学报 (Journal of Northeast Dianli University),<br>Vol. 34, No. 3, 30 June 2014 (2014-06-30), pages 45-47<br>ISSN: 1005-2992,<br>    page 45 | 1-10 |

Form PCT/ISA/210 (second sheet) (July 2022)

**INTERNATIONAL SEARCH REPORT**
Information on patent family members

International application No.

**PCT/CN2024/101304**

| Patent document cited in search report | | | Publication date (day/month/year) | Patent family member(s) | | | Publication date (day/month/year) |
|---|---|---|---|---|---|---|---|
| CN | 116930841 | A | 24 October 2023 | None | | | |
| CN | 112462303 | A | 09 March 2021 | CN | 112462303 | B | 04 May 2021 |
| CN | 103869210 | A | 18 June 2014 | CN | 103869210 | B | 10 May 2017 |
| JP | 2020092532 | A | 11 June 2020 | JP | 7176384 | B2 | 22 November 2022 |
| JP | 2013072760 | A | 22 April 2013 | JP | 5737110 | B2 | 17 June 2015 |
| WO | 2019082431 | A1 | 02 May 2019 | JP | 7151715 | B2 | 12 October 2022 |
| | | | | JP | WO2019082431 | A1 | 19 November 2020 |
| JP | 2014130057 | A | 10 July 2014 | JP | 6050111 | B2 | 21 December 2016 |
| JP | 2020054091 | A | 02 April 2020 | JP | 7034872 | B2 | 14 March 2022 |

Form PCT/ISA/210 (patent family annex) (July 2022)